**Europäisches Patentamt**

(19) **European Patent Office**

**Office européen des brevets**

(11) Publication number: **0 246 270 B1**

(12) # EUROPEAN PATENT SPECIFICATION

(45) Date of publication of patent specification:
19.06.91 Bulletin 91/25

(51) Int. Cl.$^5$: **H01S 3/025**, G02B 6/42, H01L 33/00

(21) Application number: 86906535.9

(22) Date of filing: 02.10.86

(86) International application number:
PCT/US86/02054

(87) International publication number:
WO 87/02833 07.05.87 Gazette 87/10

(54) MULTILAYER CERAMIC LASER PACKAGE.

(30) Priority: 28.10.85 US 792056

(43) Date of publication of application:
25.11.87 Bulletin 87/48

(45) Publication of the grant of the patent:
19.06.91 Bulletin 91/25

(84) Designated Contracting States:
DE FR GB NL SE

(56) References cited:
EP-A- 0 100 086
EP-A- 0 127 401
EP-A- 0 175 936
GB-A- 2 126 795
US-A- 4 309 717
Review of Scientific Instruments, vol. 55, no. 11, November 1984, (New York, US), P. Schmid et al: "Coplanar flip-chip mounting technique for picosecond devices", pages 1854-1858
Review of Scientific Instruments, vol. 52, no. 1, January 1981 (New York, US), P.R. Smith et al: "Thin film photoconductor mounting schemes for picosecond optical detectors", pages 138-140

(56) References cited:
International Journal for Hybrid Microelectronics, vol. 5, no. 2, November 1982, (Silver Spring, Maryland, US), M. Spector: "Design of a solid state laser hybrid package", pages 172-174
T.S. Laverghetta "Microwave Materials and Fabrication Techniques", 1984, Artech House, Dedham, pages 153-155

(73) Proprietor: AMERICAN TELEPHONE AND TELEGRAPH COMPANY
550 Madison Avenue
New York, NY 10022 (US)

(72) Inventor: DIETRICH, Norman, Ralph
Route 8 Box 471
Allentown, PA 18104 (US)
Inventor: HOLBROOK, Walter, Raymond
Box 3243 R.D. 3
Reading, PA 19606 (US)
Inventor: JOHNSON, Anderson, Forbes, Jr.
535 Grings Hill Road
Sinking Spring, PA 19608 (US)
Inventor: ZACHARIAS, Alfred
1135 Denmark Road
Plainfield, NJ 07062 (US)

(74) Representative: Johnston, Kenneth Graham et al
AT&T (UK) LTD. AT&T Intellectual Property Division 5 Mornington Road
Woodford Green Essex, IG8 OTU (GB)

EP 0 246 270 B1

## Description

The present invention relates to a package for optical devices, in particular to a laser package, for high frequency applications. The preamble of claim 1 corresponds to GB-A-2126795.

### Description of the Prior Art

Associated with the continuing developments in the field of optical communication systems is a need for improved packages to house the various optical devices. For example, optical systems as presently contemplated will contain active optical sources and detectors, both of which are expected to require a hermetic housing to protect the optical devices from attack by deleterious contaminants in the ambient, such as moisture in the atmosphere. Inasmuch as optical signals exit or enter the hermetic housing via optical fibers, some means to hermetically seal the fiber to the housing will be required. There exist many arrangements in the prior art which have been developed to provide these required hermetic packages. One exemplary arrangement is disclosed in U.S. Patent 4,119,363 issued to Camlibel et al on October 10, 1978. In the Camlibel et al arrangement, an optical fiber is hermetically sealed to a metal housing containing an optical device by threading and centering the fiber through a thin walled metal tube, filling the tube with solder and allowing it to cool. The solder, upon solidifying and cooling, squeezes against the fiber and forms a thermetic seal. The tube-fiber assembly is inserted through an aperture in the housing wall, the fiber is aligned with the optical device and then the tube is soldered to the wall. An alternative hermetic package for optical devices is disclosed in U.S. Patent 4,296,998 issued to W.H. Dufft on October 27, 1981. A metallic sealing cap is affixed to the body for hermetic sealing. The encapsulation is completed by evacuating the inner chamber and back-filling with nitrogen.

One factor used to measure advancement in the field of optical communication systems is the bit rate capability of the system. Continual increases in bit rate is an ever-present goal to optical system designers. As the bit rates exceed 500 Mb/s and approach the gigabit range, problems in providing the input signal to the laser with conventional electrical contacts develop. These conventional contacts begin to exhibit such a large parasitic inductance that it is not possible simply to connect a high bit rate signal source directly to the laser. Borrowing from microwave technology, a coaxial connection may be utilized in place of the electrical connection between the input source and the laser. U.S. Patent 4,309,717 issued to R.E. Cardianl on January 5, 1982 discloses such a coaxial input arrangement. As disclosed, a conventional coaxial line is inserted through a standard metal laser package, hermetically sealed in place, and connected to the laser. Although this arrangement solves the problem associated with standard electrical connections at high bit rates, the package itself is bulky, expensive and relatively difficult to manufacture.

An article entitled "Design of a Solid State Laser Hybrid Package" by M. Spector appearing in the International Journal for Hybrid Microelectronics, Vol. 5, No. 2, November 1982 at pp. 172-174 discusses in detail the technological challenges associated with package laser devices for high frequency applications. Dr. Spector describes in particular a new hybrid structure (the GTE TEC-PAC), which is a hermetic laser package of narrow design to keep the input electrical leads as short as possible, and thus reduce their associated parasitics. As discussed in the article, the limiting factor for the design is the overall width of the thermo-electric cooler mount of the laser device. Therefore, the lead lengths for this arrangement will eventually dictate a maximum input signal frequency. Further, the continual re-design of this standard package to fit high frequency applications results in increasingly expensive packages. Thus, a need remains in the prior art for a laser package capable of accommodating optical transmission at high bit rates (on the order of 500.Mb/s to at least 5Gb/s) which is rugged, inexpensive, versatile, and relatively simple to manufacture.

### Summary of the Invention

The invention is specified in claim 1.

A multilayer ceramic laser package is provided which includes a multilayer microwave input connection providing laser operation in the gigabit/second range.

In one embodiment of the invention, a versatile laser package is provided which is capable of receiving both high and low bit rate input signals by including both a multilayer microwave, (referred to as microstrip), input and conventional electrical conductor inputs, formed by metallizing different portions of particular ceramic layers of the multilayer package. In particular, a microstrip input is formed by metallizing both the top and bottom of a specific ceramic layer, the ceramic layer being of a predetermined thickness. The bottom metallization defines the stripline ground plane and the top metallization, a relatively thick metal deposit, is the conductor. Since the ceramic is electrically nonconductive and has a known dielectric constant, the combination of the two metal layers sandwiching the ceramic layer forms the microstrip input. The low frequency input, as well as

EP 0 246 270 B1

other necessary package connections (for example, those needed to power any other sensors or devices included in the package), are simply metallized on either another portion of the same layer or any other appropriate layer of the package.

Brief Description of the Drawings

FIG. 1 is a view in perspective of a multilayer ceramic laser package formed in accordance with the present invention, which has the top sealing layer, or lid, removed to show the inner cavity of the package ;

FIG. 2 is a cut-away view of the package of FIG. 1, taken along line 2-2 of FIG. 1, to illustrate the interrelationship of the dimensions of the various layers required to provide an opening for the connection of an optical fiber output, as well as the placement of the metallized portions required to form both the stripline input connection 1 and other various electrical connections ;

FIG. 3 is an alternative view of the stripline input 1 formed in accordance with the present invention taken along line 3-3 of FIG. 2 ;

FIG. 4 is alternative cut-away view of the package of FIG. 1, taken along line 4-4 of FIG. 1 ; and

FIG. 5 is a top view of the package of the present invention, as taken along line 5-5 of FIG. 4, to illustrate an interconnection of the various inputs to an exemplary laser diode transmitter.

Detailed Description

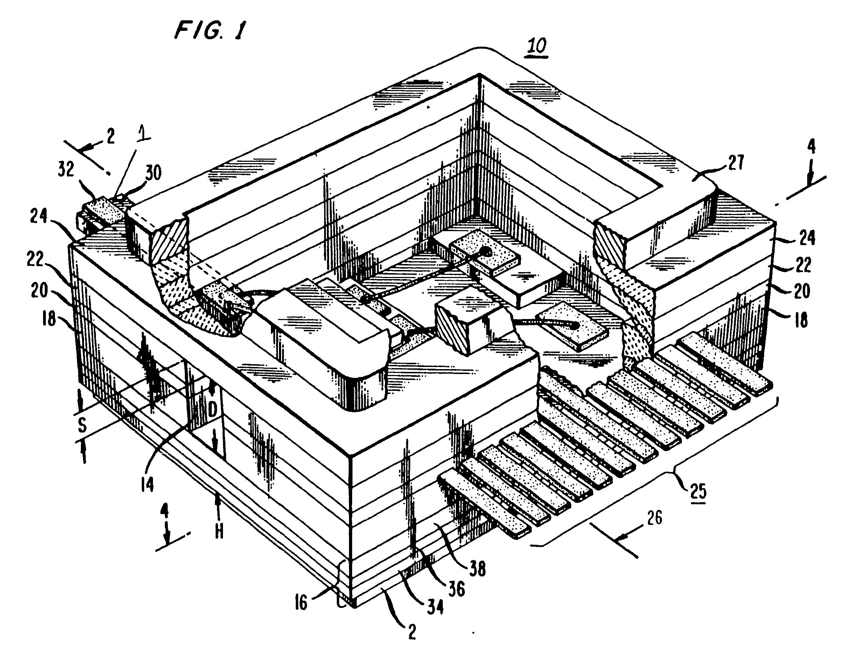

An exemplary multilayer ceramic package 10 formed in accordance with the present invention is illustrated in FIG. 1. Package 10 is illustrated without its metallic covering layer (usually formed from a combination of iron, nickel and cobalt, distributed under the tradename Kovar, and hermetically sealed to the top of the package) to clearly illustrate internal cavity 12 and the interrelationship of the various ceramic layers. It is to be noted at this point that throughout the course of the present discussion, the various layers will be referred to as "ceramic layers". However, any electrically non-conductive material (for example, glass, silicon dioxide, etc.) may be used to form the package of the present invention. Other materials may also be used, for example, plastic, if package hermeticity is not required.

To be used as a housing for an optical transmitter, package 10 of the present invention requires an opening 14 for the later attachment of an optical fiber (not shown), which is usually connected to such a package by a flange hermetically sealed to the package. The dimensions of opening 14 are determined by providing various ceramic layers of predetermined thicknesses which have cut-out portions to allow the fiber to enter the package. In particular, a first ceramic layer 16 of package 10 (which may comprise several layers, as shown) is determined to have a height H which defines the bottom of opening 14. Ceramic layers 18, 20, and 22 are stacked on first ceramic layer 16 and together comprise a height D which defines the top of opening 14. Each of ceramic layers 18, 20 and 22 include a cut-out portion, or opening, as can be seen by reference to FIG, 1, which defines the width of opening 14.

It is well-known that, high frequency signal sources exhibit an impedance Z. In order to provide optimum transmitter performance, this impedance Z should be as closely matched as possible to the transmitting optical device. However, the laser devices generally used have a impedance much smaller than the value Z associated with high frequency signal sources. Techniques have been developed for increasing the impedance as seen looking from the signal source to the laser to overcome this problem. However, it is equally important to maintain this impedance Z along the transmission path between the signal source and optical device. For high frequency applications, as stated above, parasitic inductances associated with the wire bonds and long lead lengths of conventional packages seriously affect this impedance value. Therefore, in accordance with the present invention these conventional connections are replaced by a multilayer microwave input connection for example, a microstrip, between the high frequency signal source and the optical device (the optical device being, for example, a p-n junction laser diode or an edge-emitting LED). A microwave stripline connection comprises a pair of parallel ground plates separated by a thickness of dielectric material and a conductor centrally disposed through the dielectric material. Various other multilayer arrangements may also be used and are well-known to those skilled in the design of microwave circuits. Therefore, during the course of the present discussion, any other multilayer microwave connection may be substituted for the microstrip input connection. Referring to FIG. 1, a microstrip 1 is defined by a ceramic layer 20 of package 10 which has been metallized on a portion of its underside to form a ground plane. A microstrip conductor may be formed using a standard metal film deposit 32 on top of layer 20, where the metal film is deposited to be coextensive with a portion of the ground plane 30. As seen by reference to FIG. 1, microstrip 1 is formed to be accessible from a side of ceramic package 10. In order to facilitate the connection of the ground plane to the optical devices, the top of ceramic layer 18 may be metallized to contact the ground plane when layers 18 and 20 are joined, where this additional metallization

3

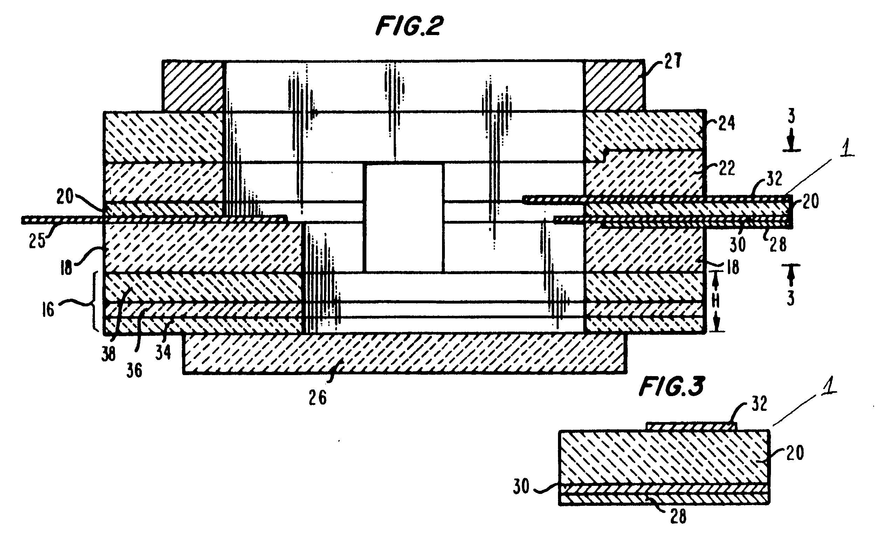

28 is shown in FIG. 2. This allows for the ground plane wire bond to be made to the top surface of a ceramic layer, instead of needing to contact the underside of layer 20. It is to be understood, however, that either type of connection may be used in practicing the present invention. Referring to FIG. 1, ceramic layer 22 merely acts as a spacer to provide the additional height S required to determine the top of opening 14. The final ceramic layer 24 is disposed over layer 22 and functions to provide the top level of opening 14. The thickness of layer 24 is determined by the total height desired for package 10.

Package 10 of the present invention also includes a plurality of conductors 25, disposed as shown in FIG. 1, to provide conventional electrical connections between devices included in package 10 and required external components – monitors, power sources, d.c. bias supplies, etc. For example, one or more of these connectors could be used to provide a low bit rate input signal to an optical device included in package 10. Other connectors could be connected to a thermoelectric cooler (TEC) which is a standard component of laser packages used to prevent the laser from overheating and malfunctioning. Temperature sensors or monitors may also be connected. As can be seen, an advantage of package 10 of the present invention is its versatility in being able to handle either high frequency or low frequency input signals. In order to facilitate the manufacture of package 10, electrical conductors 25 may be formed on the top surface of either layer 18 or 20, since these two layers must go through a metallization operation to form the metal regions required for microstrip input 1. In the illustration of FIG. 1, electrical conductors 25 are illustrated as being formed on the top of ceramic layer 18. It is to be noted, however, conductors 25 may be formed at any suitable location and, in fact, separate ones of these conductors may extend from different faces of package 10, if such a formation facilitates connection to the various external components.

FIG. 2 illustrates a cut-away side view of package 10, taken along line 2-2 of FIG. 1. This side view illustrates an additional layer 26, referred to as the base layer. Base layer 26 is used as a common thermal path, or heat sink, for the package. Layer 26 may comprise beryllia (BeO), a combination of tungsten and copper, or any other material which has a low thermal impedance. Of course, for a hermetic package, it is necessary that the material used for layer 26 will form a hermetic bond when attached to ceramic layer 16. The formation of microstrip 1 input is quite evident from the view of FIG. 2. As shown, ceramic layer 18 includes a top metallized portion 28 which forms the package ground plane where as stated above the inclusion of metallized layer 28 facilitates wire bond connections. Metal film deposit 32 is formed on top of ceramic layer 20 to define the microstrip conductor.

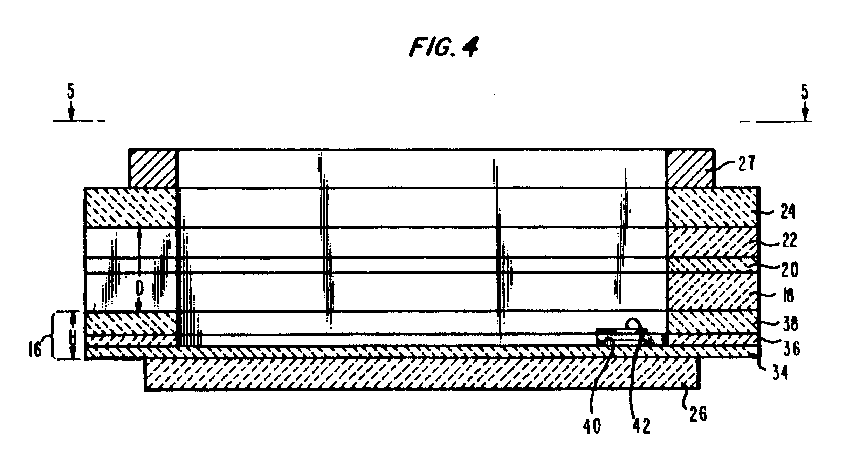

FIG. 3 contains another view of microstrip input 1, illustrating the various dimensions of the components forming an exemplary microstrip input 1. As previously discussed, other various multilayer microwave connections, for example, a stripline, may also be used. Referring to FIG. 3, the dimensions of microstrip 1 are chosen to provide the desired impedance match between the input high frequency signal source and the optical device. In the exemplary arrangement illustrated in FIG. 3, ceramic layer 20 comprises alumina ($Al_2O_3$) which has a relative permittivity $\varepsilon_r$ in the range of 9 to 9.5, depending on the purity of the alumina, and a relative permeability, $\mu_r$, of 1.0. These values of $\varepsilon_r$ and $\mu_r$ are used in conjunction with the desired characteristic impedance $Z_1$ to determine the thickness $\underline{d}$ of ceramic layer 20 and width $\underline{w}$ of metal conductor 32. From electromagnetic field theory, the capacitance $\overline{C}_1$ of microstrip 1 is defined by the equation

$$C_1 \simeq (\varepsilon/d). \quad (1)$$

The inductance $l_1$ of microstrip 1 being defined by

$$l_1 \simeq \mu(d/w), \quad (2)$$

where $\varepsilon$ and $\mu$ are the absolute permittivity and permeability, respectively. Therefore, the characteristic impedance of $Z_1$ of microstrip 1 can be approximated by the expression

$$Z_1 \simeq \sqrt{l_1/C_1} \qquad (3)$$

Thus, for a given value of $Z_1$, equations (1)-(3) may be solved for $\underline{d}$ and $\underline{w}$, given $\mu$ and $\varepsilon$.

FIG. 4 illustrates an alternative : view of an exemplary package 10, taken along line 4-4 of FIG. 1. In this view of package 10, first ceramic layer 16 is shown as comprising three separate layers 34, 36, and 38. Ceramic layer 34 is formed to have a top metallized portion 40 as shown. Similarly, ceramic layer 36 includes a metallized portion 42. These portions are used in an embodiment of the present invention to provide positive and negative connections to a thermoelectric cooler (TEC) used as described above in conjunction with a laser diode.

Ceramic layer 39 is used merely as a spacer layer, to provide a composite ceramic layer 16 of the required height H. This three layer structure is merely a suggested embodiment of package 10 of the present invention, used to provide the TEC connections as described. Alternatively, both metallized portions 40 and 42 could be formed on separate portions of ceramic layer 34. Layer 36 could then be the spacer layer used to provide the correct height H, and layer 38 would not be needed. Further, if the arrangement does not require a TEC, a single ceramic layer 16, as shown in FIG. 1, would be sufficient to form the bottom structure of package 10. Various other modifications of first ceramic layer 16 may be utilized. A cut away view of a sealing layer 27 is also illustrated in FiG. 4. This sealing layer comprises a material which when attached to the ceramic layers will form a hermetic seal. As mentioned above, Kovar is a material which satisfies this requirement. Additionally, vias (small conductive paths) are included in the various ceramic layers so that sealing ring 27 may be connected to base plate 26, thus insuring that the entire package is completely grounded.

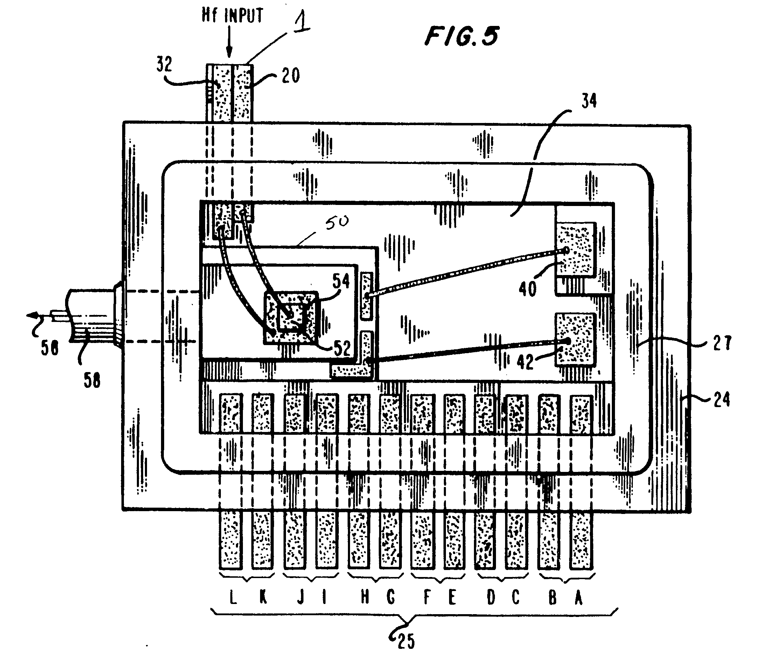

A top view in perspective of package 10, taken along line 5-5 of FIG. 4, is illustrated in FIG. 5. As shown, a thermoelectric cooler (TEC) 50 has been placed in package 10 and connected to both metallized regions 40 and 42. An exemplary p-n junction laser 52 is also illustrated as placed upon a submount 54. For the exemplary embodiment illustrated in FIG. 5, electrical connectors 25 are illustrated as including 12 separate conductors, denoted A-L. In particular, connectors A and B are used as the package ground connections between sealing layer 27 and base plate 26 as described above. Connectors C, D and E, F provide the external signal drive necessary to operate TEC 50, and are connected to TEC 50 via metal regions 40 and 42 with appropriate via holes. Connectors I, J may be utilized to provide a low frequency input signal to laser diode 52. A backface monitor output from laser 52 may be passed through connectors G, H, and connectors K, L may be connected to a temperature sensor which may mounted on TEC 50. It is to be noted that these various connections are exemplary only, and various other arrangements of input connectors may be utilized in association with the multilayer ceramic package of the present invention. As illustrated in FIG. 5, the output from the laser passes through an optical fiber 56 which is connected to package 10 via a flange 58.

## Claims

1. A package for optical devices said package comprising an electrically nonconductive housing having an opening (14) for receiving an optical fiber, CHARACTERISED IN THAT the housing comprises a multilayered structure, with metallic strips (30, 32) disposed on selected layers (20) and formed so as to extend through the housing wall, the combination of the metallic strips and the selected layers disposed therebetween forming a microwave interconnection (1) suitable for coupling a high bit rate signal source to said optical devices.

2. A package as defined in claim 1, CHARACTERISED IN THAT the multilayer microwave interconnection is a microstrip input.

3. A package as defined in claim 1, CHARACTERISED IN THAT the housing further includes a plurality of electrical conductors (25) for providing means of connecting external components to said package.

4. A package as defined in claim 1, 2 or 3, CHARACTERISED IN THAT said package further comprises a bottom support plate (26) disposed in contact with the bottom of the housing, said bottom plate being of a material with a relatively low thermal impedance to provide a heat sink for said package ; and a top sealing plate (27) disposed in contact with the top of said housing, said top plate being of conductive material and connected through said housing to provide an electrical ground for said package.

5. A package as defined in claim 2, CHARACTERISED IN THAT, each layer is defined as having top and bottom surfaces, the microstrip input connection being formed by a specific layer (20) from said plurality of layers which comprises a predetermined thickness $d$ and is metallized (30) along a predetermined portion of its bottom major surface to form a ground plane and includes a metal deposit of a predetermined width $w$ on its top major surface to form a conductor.

6. A package as defined in claim 5, CHARACTERISED IN THAT the plurality of separate layers comprises a first electrically nonconductive layer (16) of a predetermined thickness (H) and having a central cavity region ;
a second electrically nonconductive layer (18) disposed on top of said first layer and having a central cavity region, said second layer including an opening of a predetermined width for receiving an optical fiber ;
a third electrically nonconductive layer (20) disposed on top of said second layer, said third layer having a central cavity region an opening of said predetermined width, said opening coinciding with the opening in said second layer, said third layer being of a predetermined thickness (d) required for providing the microstrip input connection of a predetermined characteristic impedance, the third layer being defined as the specific layer which includes the bottom ground plane and top metal conductor, the width $w$ of said metal conductor being of a value to provide said predetermined characteristic impedance ;

a fourth electrically nonconductive layer (22) disposed on top of said third layer and having a central cavity region, said fourth layer including an opening of said predetermined width aligned with said openings in said second and third layers, said fourth layer comprising a predetermined height (S) such that the combined heights of said second, third and fourth layers are equal to a predetermined height D required for the optical fiber opening ; and

a fifth electrically nonconductive layer (24) disposed on top of said fourth layer and having a central cavity region, said fifth layer comprising a sufficient height so that said housing comprises a predetermined height.

7. A package as defined in claim 6, CHARACTERISED IN THAT the second electrically nonconductive layer is metallized along a portion of the top surface thereof so as to contact the bottom ground plane of the third layer when said third layer is disposed in contact with said second layer.

8. A package as defined in claim 1, CHARACTERISED IN THAT said electrically nonconductive material is a ceramic.

9. A package as defined in claim 1, CHARACTERISED IN THAT the ceramic is aluminum oxide.

## Ansprüche

1. Verpackung für optische Bauteile mit einem elektrisch nichtleitenden Gehäuse, das eine Öffnung (14) zur Aufnahme einer optischen Faser aufweist, dadurch gekennzeichnet, daß das Gehäuse eine mehrschichtige Struktur umfaßt, bei der metallische Streifen (30, 32) auf gewählten Schichten (20) angeordnet und so geformt sind, daß sie sich durch die Gehäusewand erstrecken, und daß die Kombination aus den metallischen Streifen und den dazwischen angeordneten, gewählten Schichten eine Mikrowellenverbindung (1) bilden, die zur Ankopplung einer Signalquelle mit hoher Bitrate an die optischen Bauteile geeignet ist.

2. Verpackung nach Anspruch 1, dadurch gekennzeichnet, daß die mehrschichtige Mikrowellenverbindung ein Mikrostreifen-Eingang ist.

3. Verpackung nach Anspruch 1, dadurch gekennzeichnet, daß das Gehäuse ferner eine Vielzahl von electrischen Leitern (25) enthält, die eine Einrichtung zur Anschaltung externer Bauteile an die Verpackung bereitstellen.

4. Verpackung nach Anspruch 1, 2 oder 3, dadurch gekennzeichnet, daß die verpackung ferner aufweist:
eine Bodenstützplatte (26), die in Kontakt mit dem Gehäuseboden angeordnet ist und aus einem Material mit verhältnismäßig niedrigem thermischen Widerstand besteht, um eine Wärmesenke für die Verpackung bereitzustellen, und
eine abdichtende Deckelplatte (27), die in Kontakt mit der Oberseite des Gehäuses angeordnet ist und aus leitendem Material besteht sowie durch das Gehäuse führt, um eine elektrische Masseverbindung für die Verpackung bereitzustellen.

5. Verpackung nach Anspruch 2, dadurch gekennzeichnet, daß jede Schicht eine Ober- und eine Unterseite besitzt, und daß die Mikrostreifen-Eingangsverbindung durch eine besondere Schicht (20) der Vielzahl von Schichten gebildet wird, wobei die besondere Schicht eine vorbestimmte Dicke (d) besitzt und entlang eines vorbestimmten Teils ihrer unteren Hauptfläche metallisiert (30) ist, um eine Masseebene zu bilden, und ein Metall enthält, daß auf einer vorbestimmten Breite (b) auf ihrer oberen Hauptfläche angeordnet ist und einen Leiter bildet.

6. Verpackung nach Ansprüch 5, dadurch gekennzeichnet, daß die Vielzahl von getrennten Schichten aufweist :
eine erste elektrisch nichtleitende Schicht (16) einer vorbestimmten Dicke (H) und einem zentralen Hohlraumbereich, eine zweite elektrisch nichtleitende Schicht (18), die auf der Oberseite der ersten Schicht angeordnet ist und einen zentralen Hohlraumbereich besitzt, wobei die zweite Schicht eine Öffnung vorbestimmter Breite zur Aufnahme einer optischen Faser beinhaltet,
eine dritte electrisch nichtleitende Schicht (20), die auf der Oberseite der zweiten Schicht angeordnet ist, wobei die dritte Schicht einen zentralen Hohlraumbereich mit einer Öffnung der vorbestimmten Breite besitzt, die Öffnung mit der Öffnung der zweiten Schicht zusammenfällt, die dritte Schicht eine vorbestimmte Dicke (d) hat, die zur Bereitstellung der Mikrostreifen-Eingangsverbindung eines vorbestimmten Wellenwiderstandes erforderlich ist, die dritte Schicht als die besondere Schicht definiert ist, die die bodenseitige Masseebene und einen oberseitigen Metalleiter enthält, und die Breite (w) des Metalleiters einen solchen Wert hat, daß sich der vorbestimmte Wellenwiderstand ergibt,
eine vierte elektrisch nichtleitende Schicht (22), die auf der Oberseite der dritten Schicht angeordnet ist und einen zentralen Hohlbereich besitzt, wobei die vierte Schicht eine Öffnung der vorbestimmten Breite ausgerichtet zu den Öffnungen der zweiten und dritten Schicht besitzt und die vierte Schicht eine vorbestimmte Höhe (S) hat, derart, daß die kombinierte Höhe der zweiten, dritten und vierten Schicht gleich einer vorbestimmten Höhe (D) ist, die für die Öffnung für die optische Faser erforderlich ist, und eine fünfte elektrisch nichtleitende Schicht (24), die auf der Oberseite der vierten Schicht angeordnet ist und einen zentralen Hohlraumbereich besitzt, wobei die fünfte Schicht eine ausreichende Höhe besitzt, damit das Gehäuse eine vorbestimmte Höhe hat.

7. Verpackung nach Anspruch 6, dadurch gekennzeichnet, daß die zweite elektrisch nichtleitende Schicht entlang eines Teils ihrer oberen Fläche metallisiert ist, um einen Kontakt mit der bodenseitigen Masseebene der dritten Schicht zu bilden, wenn die dritte Schicht in Kontakt mit der zweiten Schicht angebracht wird.

8. Verpackung nach Anspruch 1, dadurch gekennzeichnet, daß das elektrisch nichtleitende Material Keramik ist.

9. Verpackung nach Anspruch 8, dadurch gekennzeichnet, daß die Keramik Aluminiumoxid ist.


**Revendications**

1. Un boîtier pour des dispositifs optiques, ce boîtier comprenant une enveloppe non conductrice de l'électricité qui présente une ouverture (14) destinée à recevoir une fibre optique, CARACTERISE EN CE QUE l'enveloppe comprend une structure multicouche, avec des rubans métalliques (30, 32) disposés sur des couches sélectionnées (20), et formés de façon à s'étendre à travers la paroi de l'enveloppe, la combinaison des rubans métalliques et des couches sélectionnées qui sont disposées entre eux formant une interconnexion micro-onde (1) qui convient pour coupler aux dispositifs optiques une source de signal à débit binaire élevé.

2. Un boîtier selon la revendication 1, CARACTERISE EN CE QUE l'interconnexion micro-onde multicouche est une entrée de type micro-ruban.

3. Un boîtier selon la revendication 1, CARACTERISE EN CE QUE l'enveloppe comprend en outre un ensemble de conducteurs électriques (25) qui constituent des moyens de connexion de composants externes au boîtier.

4. Un boîtier selon la revendication 1, 2 ou 3, CARACTERISE EN CE QUE ce boîtier comprend en outre : une plaque de support inférieure (26), placée en contact avec le fond de l'enveloppe, cette plaque inférieure étant en une matière qui a une impédance thermique relativement faible, pour constituer un radiateur pour le boîtier ; et

une plaque de jonction hermétique supérieure (27) qui est placée en contact avec le sommet de l'enveloppe, cette plaque supérieure consistant en une matière conductrice et étant connectée à travers l'enveloppe de façon à établir une masse électrique pour le boîtier.

5. Un boîtier selon la revendication 2, CARACTERISE EN CE QUE : on définit pour chaque couche des surfaces supérieure et inférieure, et la connexion d'entrée microruban est formée par une couche spécifique (20) parmi l'ensemble de couches, qui présente une épaisseur prédéterminée $d$ et qui est métallisée (30) sur une partie prédéterminée de sa surface principale inférieure pour former un plan de masse, et qui comprend un dépôt métallique d'une largeur prédéterminée $w$ sur sa surface principale supérieure, pour former un conducteur.

6. Un boîtier selon la revendication 5, CARACTERISE EN CE QUE l'ensemble de couches séparées comprend :
une première couche non conductrice de l'électricité (16), d'une épaisseur prédéterminée (H), présentant une région de cavité centrale ;
une seconde couche non conductrice de l'électricité (18), placée sur la surface supérieure de la première couche et ayant une région de cavité centrale, cette seconde couche comprenant une ouverture de largeur prédéterminée qui est destinée à recevoir une fibre optique ;
une troisième couche non conductrice de l'électricité (20) placée sur la surface supérieure de la seconde couche, cette troisième couche ayant une région de cavité centrale et une ouverture de la largeur prédéterminée, cette ouverture coïncidant avec l'ouverture dans la seconde couche, la troisième couche ayant une épaisseur prédéterminée (d) qui est nécessaire pour établir la connexion d'entrée micro-ruban d'une impédance caractéristique prédéterminée, la troisième couche étant définie comme la couche spécifique qui comprend le plan de masse inférieur et le conducteur métallique supérieur, la largeur $w$ de ce conducteur métallique ayant une valeur qui procure l'impédance caractéristique prédéterminée ;
une quatrième couche non conductrice de l'électricité (22), placée sur la surface supérieure de la troisième couche et ayant une région de cavité centrale, cette quatrième couche comprenant une ouverture de la largeur prédéterminée qui est alignée avec les ouvertures dans les seconde et troisième couches, la quatrième couche ayant une hauteur prédéterminée (S) telle que les hauteurs combinées des seconde, troisième et quatrième couches soient égales à une hauteur prédéterminée D qui est nécessaire pour l'ouverture de fibre optique ; et

une cinquième couche non conductrice de l'électricité (24) placée sur la surface supérieure de la quatrième couche et ayant une région de cavité centrale, cette cinquième couche ayant une hauteur suffisante pour que l'enveloppe ait une hauteur prédéterminée.

7. Un boîtier selon la revendication 6, CARACTERISE EN CE QUE la seconde couche non conductrice de l'électricité est métallisée sur une partie de sa surface supérieure, de façon à établir un contact avec le plan de masse inférieur de la troisième couche, lorsque cette troisième couche est placée en contact avec la seconde couche.

8. Un boîtier selon la revendication 1, CARACTERISE EN CE QUE la matière non conductrice de l'électricité est une céramique.

9. Un boîtier selon la revendication 8, CARACTERISE EN CE QUE la céramique est de l'oxyde d'aluminium.

FIG. 1

FIG.2

FIG.3

EP 0 246 270 B1

# FIG. 4

FIG.5